# EUROPEAN PATENT APPLICATION

(11) **EP 1 906 417 A2**
(43) Date of publication of application: **02.04.2008**
(21) Application number: 07108452.9
(22) Date of filing: 18.05.2007
(51) Int. Cl.: H01G 9/20

(54) **Dye-sensitized solar cell and method of manufacturing the same**

(30) Priority: 29.09.2006 KR 20060096412
(71) Applicant: ELECTRONICS AND TELECOMMUNICATIONS RESEARCH INSTITUTE, Daejeon-shi (KR)
(72) Inventor: Jun, Yongseok, Seoul (KR); Kang, Mangu, Daejeon-city (KR); Kim, Jong Dae, Daejeon-city (KR)
(74) Representative: Betten & Resch

(57) **Abstract**

A dye-sensitized solar cell in which an insulating layer is formed on exposed surfaces of a semiconductor oxide layer in a semiconductor electrode and a conductive substrate, and a method of manufacturing the dye-sensitized solar cell are provided. The dye-sensitized solar cell includes a semiconductor electrode and an opposing electrode disposed to face each other, and an electrolyte solution interposed between the electrodes. The semiconductor electrode includes a conductive substrate, a semiconductor oxide layer formed on the semiconductor electrode, a dye molecule layer adhered to the surface of the semiconductor oxide layer, and an insulating layer formed on the surfaces of the semiconductor oxide layer exposed through the dye molecule layer and the conductive substrate. The insulating layer is formed of a self-assembling organic layer which is self-assembled on the surfaces of the semiconductor oxide layer and the conductive substrate by a chemical bond.

## Description

### CROSS-REFERENCE TO RELATED PATENT APPLICATION

This application claims the benefit of Korean Patent Application No. 10-2006-0096412, filed on September 29, 2006, in the Korean Intellectual Property Office, the disclosure of which is incorporated herein in its entirety by reference.

### BACKGROUND OF THE INVENTION

### 1. Field of the Invention

The present invention relates to a solar cell, and more particularly, to a dye-sensitized solar cell including a semiconductor oxide layer on which dye molecules are coated.

### 2. Description of the Related Art

Unlike silicon solar cells manufactured using an existing p-n junction, a dye-sensitized solar cell is a photoelectrochemical solar cell whose main constituents are photosensitive dye molecules that are capable of generating electron-hole pairs by absorbing visible light, and a transition metal oxide which transfers generated electrons. A representative example of such a dye-sensitized solar cell is a dye-sensitized solar cell suggested by Graetzel et al. in Switzerland (U.S Patent Publication Nos. 4,927,721 and 5,350,644). The dye-sensitized solar cell suggested by Graetzel et al. is formed of a semiconductor electrode, an opposing electrode, and an electrolyte solution filled between both electrodes, wherein the semiconductor electrode consists of nanocrystalline titanium dioxides (TiO₂) on which dye molecules are coated and the opposing electrode is coated with platinum or carbon. Since the photochemical solar cell can be produced at a lower production cost per unit electric power than conventional silicon solar cells, it is attracting much attention.

The principle of operation of the dye-sensitized solar cell is as follows.

Electrons are injected into a conduction band of nanocrystalline titanium dioxides from the exited dyes due to sunlight. The injected electrons pass through nanocrystalline titanium dioxides to reach a conductive substrate and are transported to an external circuit After performing electrical work in the external circuit, the electrons return and are injected into titanium dioxide through the opposing electrode by an oxidation/reduction electrolyte using its role of transporting electrons so as to reduce dyes having insufficient electrons, thereby completing the operation of the dye-sensitized solar cell. Here, when the electrons injected from the dyes pass through a nanocrystalline titanium dioxide layer and the conductive substrate, some of the injected electrons can remain in an empty surface energy level in the surface of the nanocrystalline titanium dioxides before being transported to the external circuit. In this case, the electrons are allowed to react with the oxidation/reduction electrolyte, and are dissipated inefficiently. In addition, the electrons generated by light may also dissipated on the surface of the conductive substrate and thus energy conversion efficiency is decreased.

### SUMMARY OF THE INVENTION

The present invention provides a dye-sensitized solar cell which can prevent dissipation of electrons due to an interaction between electrons and an oxidation/reduction electrolyte on a surface of a semiconductor oxide or on a surface of a conductive substrate injected from dyes.

The present invention also provides a method of manufacturing a dye-sensitized solar cell, wherein the dye-sensitized solar cell can prevent dissipation of electrons due to an interaction between electrons and an oxidation/reduction electrolyte on a surface of a semiconductor oxide or on a surface of a conductive substrate injected from dyes.

According to an aspect of the present invention, there is provided a dye-sensitized solar cell including: a semiconductor electrode and an opposing electrode disposed to face each other, and an electrolyte solution interposed between the electrodes, wherein the semiconductor electrode comprises a conductive substrate, a semiconductor oxide layer formed on the semiconductor electrode, a dye molecule layer adhered to the surface of the semiconductor oxide layer, and an insulating layer formed on the surfaces of the semiconductor oxide layer exposed through the dye molecule layer and the conductive substrate.

The insulating layer may be formed of a self-assembling organic layer which is composed of an insulating organic compound, wherein the insulating organic compound is self-assembled on the surfaces of the semiconductor oxide layer exposed through the dye molecule layer and the conductive substrate by a chemical bond.

For example, the self-assembling organic layer may be formed of a molecular layer in which one compound selected from the group consisting of a silane compound, a phosphate compound, a sulphuric acid compound, and a carboxylic acid compound is self-assembled.

In addition, the self-assembling organic layer may be formed of a molecular layer in which the silane compound is self-assembled, the silane compound having a structure selected from the group consisting of R₁SiHR₂R₃, R₁SiXR₂R₃ (X is Cl, Br, or I), and R₁SiRR₂R₃ (R is methoxy, ethoxy, or t-butoxy) (where R₁, R₂, and R₃ are C₁-C₂₄ alkane, alkene, or alkynes, each substituted or unsubstituted with fluorine).

The self-assembling organic layer may be also formed of a molecular layer in which the phosphate compound is self-assembled, the phosphate compound having a structure of PR₁R₂R₃R₄ (where R₁, R₂, R₃, and R₄ are C₁-C₂₄ alkane, alkene, or alkynes, and each substituted or unsubstituted with fluorine and at least one of R₁, R₂, R₃, and R₄ is -OH or -O). The self-assembling organic layer may be also formed of a molecular layer in which the sulphuric acid compound is self-assembled, the sulphuric acid compound having a structure of SR₁R₂R₃R₄ (R₁, R₂, R₃, and R₄ are a C₁-C₂₄ alkane, an alkene, or alkynes, and each substituted or unsubstituted with fluorine and at least one of R₁, R₂, R₃, and R₄ is -OH or -O). The self-assembling organic layer may be also formed of a molecular layer in which the carboxylic acid compound is self-assembled, the carboxylic acid compound having a structure of R₁COOH or R₂COO⁻ (R₁ and R₂ are a C₁-C₂₄ alkane, an alkene, or alkynes, and each substituted or unsubstituted with fluorine).

According to another aspect of the present invention, there is provided a method of manufacturing a dye-sensitized solar cell, the method including: forming a semiconductor electrode; forming an opposing electrode; arranging the semiconductor electrode and the opposing electrode to face each other; and injecting an electrolyte solution in a space between the semiconductor electrode and the opposing electrode, wherein the forming of the semiconductor electrode comprises forming a semiconductor oxide layer on a conductive substrate, adhering a dye molecule layer onto the surface of the semiconductor oxide layer, and forming an insulating layer on the surfaces of the semiconductor oxide layer exposed through the dye molecule layer and the conductive substrate.

The method may further include forming a self-assembling organic layer, wherein the self-assembling organic layer is self-assembled on the surfaces of the semiconductor oxide layer exposed through the dye molecule layer and the conductive substrate by a chemical bond, for forming the insulating layer.

The forming of the self-assembling organic layer may include dipping a resultant structure on which the dye molecule layer is formed, in a hydrophobic organic solvent in which at least one compound selected from the group consisting of a silane compound, a phosphate compound, a sulphuric acid compound, and a carboxylic acid compound is dissolved. In addition, the forming of the self-assembling organic layer may include providing in a gaseous state at least one compound selected from the group consisting of a silane compound, a phosphate compound, a sulphuric acid compound, and a carboxylic acid compound to the surface of the resultant structure on which the dye molecule layer is formed. The forming of the self-assembling organic layer may be performed under a drier condition than the atmosphere.

In the dye-sensitized solar cell according to the present invention, the surface of the semiconductor oxide layer contacting an oxidation/reduction electrolyte and the surface of the conductive substrate are covered with the insulating layer and thus electron dissipation which could occur while electrons generated in response to light are transported to the external circuit in the operational process of the dye-sensitized solar cell, is prevented, thereby significantly improving energy conversion efficiency. In addition, since the self-assembly organic layer can be formed on a desired portion of the semiconductor electrodes by a relatively simple and easy process, competitiveness of the dye-sensitized solar cell in the market can be significantly improved.

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view schematically illustrating a dye-sensitized solar cell according to an embodiment of the present invention;
FIG. 2 is an enlarged cross-sectional view illustrating a semiconductor electrode of the dye-sensitized solar cell of FIG. 1 in detail according to an embodiment of the present invention; and
FIG. 3 is a graph evaluating an electric current density and voltage of dye-sensitized solar cells according to an embodiment of the present invention.

### DETAILED DESCRIPTION OF THE INVENTION

Hereinafter, the present invention will be described more fully with reference to the accompanying drawings, in which exemplary embodiments of the invention are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art. In the drawings, like reference numerals denote like elements, and the sizes and thicknesses of layers and regions are exaggerated for clarity.

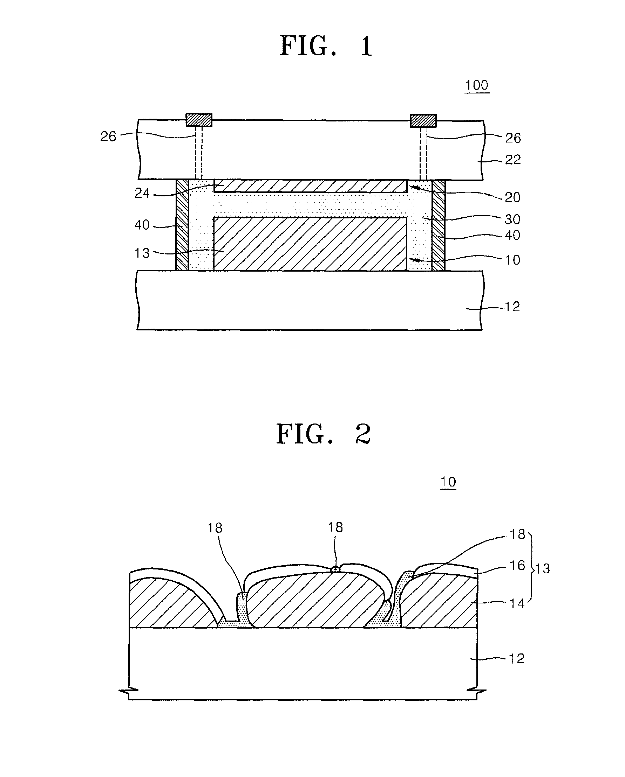

FIG. 1 is a cross-sectional view schematically illustrating a dye-sensitized solar cell 100 according to an embodiment of the present invention.

Referring to FIG. 1, the dye-sensitized solar cell 100 according to an embodiment of the present invention includes a semiconductor electrode 10, an opposing electrode 20, and an electrolyte solution 30 filled between the semiconductor electrode 10 and the opposing electrode 20.

FIG. 2 is an enlarged cross-sectional view illustrating the semiconductor electrode 10 of the dye-sensitized solar cell 100 in detail according to an embodiment of the present invention.

Referring to FIGS. 1 and 2, the semiconductor electrode 10 is formed of a transparent conductive substrate 12 and an electron transport layer 13 disposed on the conductive substrate 12 to transmit electrons to the conductive substrate 12. The electron transport layer 13 includes a semiconductor oxide layer 14 formed on the conductive substrate 12 and a dye molecule layer 16 adhered to the semiconductor oxide layer 14. In order to prevent dissipation of electrons due to a reaction with the electrolyte solution 30, which causes inefficiency, an insulating layer 18 is formed on the surface of the semiconductor oxide layer 14 exposed through the dye molecule layer 16 in the electron transport layer 13 and on the surface of the conductive substrate 12. The insulating layer 18 may be formed of a self-assembling organic layer.

The conductive substrate 12 may be formed of indium tin oxide (ITO), fluorine-doped tin oxide (FTO), or a glass substrate on which SnO₂ is coated.

The semiconductor oxide layer 14 may be formed of titanium dioxide (TiO₂), tin-dioxide (SnO₂), zinc oxide (ZnO), or a combination thereof. The semiconductor oxide layer 14 may have a thickness of 5 to 15 µm.

The dye molecule layer 16 may be formed of a ruthenium complex.

On the surface of the conductive substrate 12, the insulating layer 18 is selectively formed on an exposed portion on the conductive substrate 12 and an exposed portion of the semiconductor oxide layer 14 not covered by the dye molecule layer 16. When the insulating layer 18 is a self-assembling organic layer, the self-assembling organic layer is self-assembled on the surfaces of the conductive substrate 12 and the semiconductor oxide layer 14 due to a chemical bond occurring between metal atoms contained in the conductive substrate 12 and the semiconductor oxide layer 14. The self-assembling organic layer formed of the insulating layer 18 may be formed of a one-molecule layer. In addition, the thickness of the self-assembling organic layer may be adjusted according to the molecular length of materials forming the molecular layer. The self-assembling organic layer forming the insulating layer 18 may be formed of an insulating organic compound having no capacity to transport electrons or holes. The source compound of the self-assembling organic layer may be selected from organic molecules including a functional group which can be selectively self-assembled by a chemical bond on a conductive surface, such as a silane compound, a phosphate compound, a sulphuric acid compound, and a carboxylic acid compound. The organic molecules which can form the self-assembling organic layer will be described more fully later on.

The opposing electrode 20 includes a conductive substrate 22 and a metal layer 24 coated on the conductive substrate 22. The metal layer 24 may be formed of a platinum layer. The conductive substrate 22 may be formed of ITO, FTO, or a glass substrate on which SnO₂ is coated.

The metal layer 24 of the opposing electrode 20 is disposed to face the electron transport layer 13 of the semiconductor electrode 10.

The electrolyte solution 30 filled in a space between the semiconductor electrode 10 and the opposing electrode 20 may be formed of an imidazole group compound and iodine. For example, the electrolyte solution 30 may be a I₃⁻/I⁻ electrolyte solution in which 0.70 M of 1-vinyl-3-methyl-immidazolium iodide, 0.10 M of Lil, 40 mM of iodine (I₂), and 0.125 M of 4-tert-butylpyridine are dissolved in 3-methoxypropionitrile.

The electrolyte solution 30 is filled in the space between the semiconductor electrode 10 and the opposing electrode 20 through a micro hole 26 formed in the conductive substrate 22 of the opposing electrode 20, wherein the space is defined by a polymer layer 40.

The dye-sensitized solar cell 100 of FIGS. 1 and 2 according to an embodiment of the present invention operates in the following manner.

When sunlight which penetrates the conductive substrate 12 of the semiconductor electrode 10 is absorbed into the dye molecule layer 16 adhered onto the semiconductor oxide layer 14, the materials forming the dye molecule layer 16 are excited and thus electrons are injected into a conduction band of the semiconductor oxide layer 14. The electrons injected into the semiconductor oxide layer 14 are delivered to the conductive substrate 12, which is adjacent to the semiconductor oxide layer 14, through an interface between nano-scale fine particles constituting the semiconductor oxide layer 14 and then are transported to the opposing electrode 20 through an external electrical wire circuit (not illustrated).

The dye molecule layer 16, which is oxidized as a result of an electron transition, receives electrons provided by an oxidation-reduction action (3I⁻ → I₃⁻ + 2e⁻) of iodine ions disposed in the electrolyte solution 30 and the electrons are reduced again. The oxidized iodine ion (I₃⁻) is reduced again by the electrons reached the opposing electrode 20. Accordingly, the operational process of the dye-sensitized solar cell 100 is completed.

As described above, in the dye-sensitized solar cell 100 according to the present invention, since the conductive substrate 12 and the portion of the semiconductor oxide layer 14 exposed by the dye molecule layer 16, which constitute the semiconductor electrode 10, are covered by the insulating layer 18, a region which can easily form a path of an electron dissipation can be prevented by the dye molecule layer 16 which is a self-assembling organic layer and thus energy conversion efficiency can be significantly improved.

Next, a method of manufacturing the dye-sensitized solar cell 100 according to the present invention will be described.

In order to manufacture the semiconductor electrode 10, which is the cathode, the conductive substrate 12 on which the semiconductor oxide layer 14 is formed is prepared. The semiconductor oxide layer 14 may have a thickness of 5 to 15 µm. Then, the conductive substrate 12 on which the semiconductor oxide layer 14 is formed is immersed in a dye solution formed of ruthenium complexes for 24 hours or more and thus the surface of the semiconductor oxide layer 14 is coated with the dye molecule layer 16.

The resultant structure on which the dye molecule layer 16 is formed is dried under a N₂ atmosphere to remove alcohol-based organic solvent from the surface of the resultant structure.

Next, the insulating layer 18 is formed on the surfaces of the conductive substrate 12 and the semiconductor oxide layer 14 that are exposed through the dye molecule layer 16. In order for the insulating layer 18 to be formed as a self-assembling organic layer, the self-assembling organic layer is formed on the surfaces of the conductive substrate 12 and the semiconductor oxide layer 14 that are exposed through the dye molecule layer 16 under a drier condition than the atmosphere. In order to create a dry condition, the self-assembling organic layer can be formed in a dry room maintained at a dew point temperature of approximately -60 to -10 □.

In an exemplary method of manufacturing the self-assembling organic layer, a process of dipping the resultant on which the semiconductor oxide layer 14 and the dye molecule layer 16 are formed, in a hydrophobic organic solvent in which a predetermined organic compound is dissolved in the dry room for 30 minutes to one day can be used. The organic solvent may be formed of, for example, a polar solvent such as an alcohol or acetone, or a nonpolar solvent such as benzene, toluene, hexane, butane, or isooctane.

In another exemplary method of manufacturing the self-assembling organic layer, a process of coating the surfaces of the conductive substrate 12 and the semiconductor oxide layer 14 with a predetermined organic compound which is provided in a gaseous state under a vacuum atmosphere can be used.

The source compound used to manufacture the self-assembling organic layer may be selected from an insulating organic compound having no capacity for transporting electrons or holes. In particular, the source material of the self-assembling organic layer may be selected from organic molecules including a functional group which can be selectively self-assembled by a chemical bond on a conductive surface. For example, the source material may be a silane compound, a phosphate compound, a sulphuric acid compound, or a carboxylic acid compound.

When the silane compound is used as the source material to manufacture the self-assembling organic layer, the silane compound may have a structure selected from the group consisting of R₁SiHR₂R₃, R₁SiXR₂R₃ (X is Cl, Br, or I), and R₁SiRR₂R₃ (R is methoxy, ethoxy, or t- butoxy) (where R₁, R₂, and R₃ are a C₁-C₂₄ alkane, an alkene, or alkynes, and each of R₁, R₂, and R₃ are substituted or unsubstituted with fluorine).

For example, alkylsilane, alkyltrichlorosilane, alkoxy alkylsilane, trialkoxy alkylsilane, and dialkoxy dialkylsilane including a C₁-C₂₄ alkyl group or alkoxy group can be used.

When the phosphate compound is used as the source material to manufacture the self-assembling organic layer, the phosphate compound has a functional group selected from -PO₄, -PO₃, -PO₂, and - PO. The phosphate compound may have a structure of PR₁R₂R₃R₄ (where R₁, R₂, R₃, and R₄ are C₁-C₂₄ alkane, alkene, or alkynes, and each of R₁, R₂, R₃ and R₄ are substituted or unsubstituted with fluorine and at least one of R₁, R₂, R₃, and R₄ is -OH or -O). When at least one of R₁, R₂, R₃, and R₄ is -O, the phosphate compound may exist in the form of complex having metallic ion. For example, an alkyl phosphoric acid, alkyl hyposphorous acid, and phosphorous acid having a C₁-C₂₄ alkyl group substituted or unsubstituted with fluorine can be used.

When a sulphuric acid compound is used as the source material to manufacture the self-assembling organic layer, the sulphuric acid compound has a functional group selected from -SO₄, -SO₃, -SO₂, and -SO. The sulphuric acid compound may have a structure of SR₁R₂R₃R₄ (R₁, R₂, R₃, and R₄ are C₁-C₂₄ alkane, alkene, or alkynes, and each of R₁, R₂, R₃ and R₄ are substituted or unsubstituted with fluorine and at least one of R₁, R₂, R₃, and R₄ is -OH or -O). When at least one of R₁, R₂, R₃, and R₄ is -O, the sulphuric acid compound may exist in forms of complex having metallic ion. For example, a sulfuric acid, sulfurous acid, and metallic metal ion complexes thereof, i.e., sodium sulfate and potassium sulfite, can be used.

When the carboxylic acid compound is used as the source material to manufacture the self-assembling organic layer, the carboxylic acid compound has a functional group of -COOH or -COO-. The carboxylic acid compound may have a structure of R₁COOH or R₂COO⁻ (R₁ and R₂ are C₁-C₂₄ alkane, alkene, or alkynes, each substituted or unsubstituted with fluorine). For example, methanoic acid, ethanoic acid, propanoic acid, butanoic acid, malonic acid, oxalic acid, succinic acid, phthalic acid, glutaric acid, adipic acid, and benzoic acid can be used.

Manufacture of the semiconductor electrode 10, which is the cathode, is completed by forming the insulating layer 18 on the surfaces of the conductive substrate 12 and the semiconductor oxide layer 14 that are exposed through the dye molecule layer 16, as described above.

In order to manufacture the opposing electrode 20, which is the anode, the metal layer 24, for example, a platinum layer, is coated on the transparent conductive substrate 22 on which ITO, FTO, or SnO₂ is coated.

Next, the anode and the cathode are assembled. That is, the metal layer 24 and the semiconductor oxide layer 14 on which the dye molecule layer 16 is adhered are formed to face each other, and the conductive surfaces are disposed inside in the anode and the cathode. In this case, the polymer layer 40, which has a thickness of 30 to 50µm, and is formed of, for example, SURLYN (manufactured by Du Pont), is interposed between the anode and the cathode and then both electrodes are closely adhered to each other on a heating plate of 100 to 140□ under an atmospheric pressure of 1 to 3. Due to heat and pressure, the polymer layer 40 is strongly adhered onto the surfaces of both electrodes. Then, the electrolyte solution 30 is filled in the space between both electrodes through the micro hole 26 formed in the conductive substrate 22. After the filling of the electrolyte solution 30 is completed, SURLYN and a thin glass are rapidly heated to close the micro hole 26.

Hereinafter, manufacturing examples of the dye-sensitized solar cell according to the present invention will be described more fully.

### Example 1

### Manufacturing a dye-sensitized solar cell

A first TiO₂ nano-particle layer was formed on a FTO substrate by a screen printing method using synthesized TiO₂ paste. After performing a process of drying and sintering under 500 □, a second TiO₂ nano-particle layer including light scattering particles having a diameter of 200 to 400 nm was formed on the first TiO₂ nano-particle layer by a screen printing method and then was dried and sintered to manufacture a TiO₂ thin film which was a bilayer having a thickness of 20 µm.

The resulting structure on which the TiO₂ thin film was formed was added to an alcoholic solution in which ruthenium dye (4,4'-dicarboxy-2,2-bupyridine)bis(thiocyanato)ruthenium(II): N3) was dissolved, and the dye was adhered to the surface of the TiO₂ thin film. The resulting structure on which the dye was adhered was washed using ethanol and dried. Samples prepared after performing such a process were divided into three groups.

Each of triethoxyoctylsilane, octadecyltricholorosilane, and methylphosphonic acid was dissolved in a toluene solution to have a concentration of 5 mM to prepare solutions used for self-assembling of each different organic compound. Then, the three groups of samples were dipped respectively in the toluene solutions in which each of triethoxyoctylsilane, octadecyltricholorosilane, and methylphosphonic acid was dissolved for 6 hours. Then, an insulating layer was formed on a portion of the surface of the TiO₂ thin film where the dye was not adhered and an exposed surface of the FTO substrate to complete a semiconductor electrode, wherein the insulating layer was a self-assembling organic layer.

A conductive glass substrate on which a H₂PtCl₆ solution was coated was heated for 30 minutes at 450 □ to prepare counter electrodes.

The semiconductor electrodes and the counter electrodes were arranged so their respective conductive surfaces faced each other. Then, a polymer layer formed of SURLYN (manufactured by Du Pont) was interposed between the semiconductor electrodes and the counter electrodes to closely adhere the semiconductor electrodes and the counter electrodes. Next, I₃⁻/I⁻ electrolyte solution in which 0.70 M of 1-vinyl-3-methyl-immidazolium iodide, 0.10 M of Lil, 40 mM of I₂ (iodine), 0.125 M of 4-tert-butylpyridine were dissolved in 3- methoxypropionitrile was filled in the space between both electrodes to complete a dye-sensitized solar cell.

### Example 2

### Comparative Example

For comparison purposes, a dye-sensitized solar cell was manufactured in the same manner as in Example 1 except that manufacture of the self-assembling organic layer was excluded.

### Example 3

### Measuring photo voltage and photo current

In order to evaluate light conversion efficiency of the dye-sensitized solar cells manufactured in Example 1, photo voltages and photo currents of the dye-sensitized solar cells were measured as follows. In order to do so, a solar simulator formed of a source meter (Keithley 2400 SourceMeter^{®}) was used. Here, a Xenon lamp (Oriel, 91193) was used as a light source.

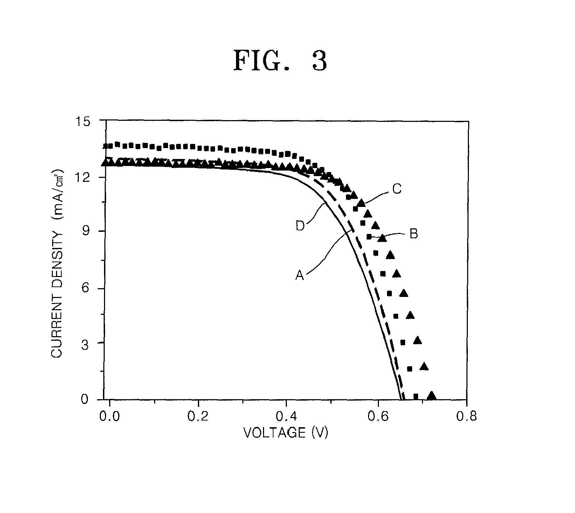

FIG. 3 is a graph evaluating an electric current density and voltage of the dye-sensitized solar cells of Example 1 according to an embodiment of the present invention.

Referring to FIG. 3, the curve illustrates electric current densities and voltages of the dye-sensitized solar cells "A" "B" and "C", wherein "A" "B" and "C" refer to solar cells in which a self-assembling organic layer was formed using triethoxyoctylsilane, octadecyltricholorosilane, and methylphosphonic acid, respectively. In addition, "D" refers to the electric current density and voltage of the dye-sensitized solar cells used for comparison purposes manufactured in Example 2

According to the result of FIG. 3, the open circuit voltages and electrical current densities of the dye-sensitized solar cells "A" "B" and "C" in which the self-assembling organic layer was formed were each improved compared to that of the dye-sensitized solar cells used for comparison purposes manufactured in Example 2. In addition, among the dye-sensitized solar cells ("A" "B" and "C") according to the present invention, the dye-sensitized solar cell in which the self-assembling organic layer was formed using a phosphate compound ("C") has better efficiency than the dye-sensitized solar cell in which the self-assembling organic layer was formed using a silane compound ("A").

Electrical characteristics of each of the dye-sensitized solar cells ("A" "B" and "C") manufactured in Example 1 according to the present invention and the dye-sensitized solar cell used for comparison purposes ("D") manufactured in Example 2 are illustrated in Table 1.

**[Table 1]**

| | A (Triethoxy -octylsilane) | B (Octadecyltrichlorosilane) | C (Methylphosphonic acid) | D (reference) |
|---|---|---|---|---|
| Open Circuit Voltage (V oc) V | 0.661 | 0.687 | 0.723 | 0.654 |
| Short Circuit Current (J sc) mA/cm² | 12.81 | 12.93 | 13.61 | 12.71 |
| Fill Factor | 0.641 | 0.637 | 0.655 | 0.630 |
| Efficiency (%) | 5.43 | 5.658 | 6.45 | 5.23 |

As described above, in the dye-sensitized solar cell according to the present invention, the surface of the semiconductor oxide layer exposed through the dye molecule layer in the semiconductor electrode and the surface of the conductive substrate are covered with the insulating layer. In order to form the insulating layer, the self-assembling organic layer can be formed, wherein the self-assembling organic layer is self-assembled on the surfaces of the semiconductor oxide layer exposed through the dye molecule layer and the conductive substrate due to a chemical bond. Since the surface of the semiconductor oxide layer contacting an oxidation/reduction electrolyte and the surface of the conductive substrate are covered with a protective film formed of the insulating layer, dissipation of electrons injected from dyes to the nano-particle semiconductor oxide layer in response to light, can be prevented. In addition, the insulating layer is also formed on the surface of the conductive substrate exposed by the semiconductor oxide layer and thus a reaction of the electrons and oxidation/reduction electrolyte occurring through the surface of the conductive substrate is prevented, thereby preventing electron dissipation and increasing efficiency. Therefore, electron dissipation which could occur while electrons generated in response to light are transported to the external circuit in the operational process of the dye-sensitized solar cell, is prevented, and thus, energy conversion efficiency can be significantly improved. In addition, since the insulating layer can be formed on a desired portion of the semiconductor electrodes by a relatively simple and easy process using insulating organic molecules having a functional group, wherein the functional group is selectively self-assembled on the conductive surface only, competitiveness of the dye-sensitized solar cell in the market can be significantly improved.

While the present invention has been particularly shown and described with reference to exemplary embodiments thereof, it will be understood by those of ordinary skill in the art that various changes in form and details may be made therein without departing from the spirit and scope of the present invention as defined by the following claims.

In summary an embodiment of the invention can be described as follows:

A dye-sensitized solar cell in which an insulating layer is formed on exposed surfaces of a semiconductor oxide layer in a semiconductor electrode and a conductive substrate, and a method of manufacturing the dye-sensitized solar cell are provided. The dye-sensitized solar cell includes a semiconductor electrode and an opposing electrode disposed to face each other, and an electrolyte solution interposed between the electrodes. The semiconductor electrode includes a conductive substrate, a semiconductor oxide layer formed on the semiconductor electrode, a dye molecule layer adhered to the surface of the semiconductor oxide layer, and an insulating layer formed on the surfaces of the semiconductor oxide layer exposed through the dye molecule layer and the conductive substrate. The insulating layer is formed of a self-assembling organic layer which is self-assembled on the surfaces of the semiconductor oxide layer and the conductive substrate by a chemical bond.

## Claims

1. A dye-sensitized solar cell comprising:
a semiconductor electrode and an opposing electrode disposed to face each other, and an electrolyte solution interposed between the electrodes,
wherein the semiconductor electrode comprises a conductive substrate, a semiconductor oxide layer formed on the semiconductor electrode, a dye molecule layer adhered to the surface of the semiconductor oxide layer, and an insulating layer formed on the surfaces of the semiconductor oxide layer exposed through the dye molecule layer and the conductive substrate.

2. The dye-sensitized solar cell of Claim 1, wherein the insulating layer is formed of a self-assembling organic layer which is composed of an insulating organic compound, wherein the insulating organic compound is self-assembled on the surfaces of the semiconductor oxide layer exposed through the dye molecule layer and the conductive substrate by a chemical bond.

3. The dye-sensitized solar cell of Claim 2, wherein the self-assembling organic layer is formed of a molecular layer in which one compound selected from the group consisting of a silane compound, a phosphate compound, a sulphuric acid compound, and a carboxylic acid compound is self-assembled.

4. The dye-sensitized solar cell of Claim 2, wherein the self-assembling organic layer is formed of a molecular layer in which the silane compound is self-assembled, the silane compound having a structure selected from the group consisting of R₁SiHR₂R₃, R₁SiXR₂R₃ (X is Cl, Br, or I), and R₁SiRR₂R₃ (R is methoxy, ethoxy, or t-butoxy) (where R₁, R₂, and R₃ are C₁-C₂₄ alkane, alkene, or alkynes, each substituted or unsubstituted with fluorine).

5. The dye-sensitized solar cell of Claim 2, wherein the self-assembling organic layer is formed of a molecular layer in which the phosphate compound is self-assembled, the phosphate compound having a structure of PR₁R₂R₃R₄ (where R₁, R₂, R₃, and R₄ are C₁-C₂₄ alkane, alkene, or alkynes, and each substituted or unsubstituted with fluorine and at least one of R₁, R₂, R₃, and R₄ is -OH or -O).

6. The dye-sensitized solar cell of Claim 2, wherein the self-assembling organic layer is formed of a molecular layer in which the sulphuric acid compound is self-assembled, the sulphuric acid compound having a structure of SR₁R₂R₃R₄ (R₁, R₂, R₃, and R₄ are a C₁-C₂₄ alkane, an alkene, or alkynes, and each substituted or unsubstituted with fluorine and at least one of R₁, R₂, R₃, and R₄ is -OH or -O).

7. The dye-sensitized solar cell of Claim 2, wherein the self-assembling organic layer is formed of a molecular layer in which the carboxylic acid compound is self-assembled, the carboxylic acid compound having a structure of R₁COOH or R₂COO⁻ (R₁ and R₂ are a C₁-C₂₄ alkane, an alkene, or alkynes, and each substituted or unsubstituted with fluorine).

8. The dye-sensitized solar cell of any of the preceding claims, wherein the conductive substrate is formed of indium tin oxide (ITO), fluorine-doped tin oxide (FTO), or a glass substrate on which SnO₂ is coated.

9. The dye-sensitized solar cell of any of the preceding claims, wherein the dye molecule layer is formed of a ruthenium complex.

10. The dye-sensitized solar cell of any of the preceding claims, wherein the semiconductor oxide layer is formed of titanium dioxide (TiO₂), tin-dioxide (SnO₂), zinc oxide (ZnO), or a combination thereof.

11. The dye-sensitized solar cell of any of the preceding claims, wherein the opposing electrode includes the conductive substrate and a metal layer coated on the conductive substrate.

12. A method of manufacturing a dye-sensitized solar cell, the method comprising:
forming a semiconductor electrode;
forming an opposing electrode;
arranging the semiconductor electrode and the opposing electrode to face each other; and
injecting an electrolyte solution in a space between the semiconductor electrode and the opposing electrode,
wherein the forming of the semiconductor electrode comprises forming a semiconductor oxide layer on a conductive substrate, adhering a dye molecule layer onto the surface of the semiconductor oxide layer, and forming an insulating layer on the surfaces of the semiconductor oxide layer exposed through the dye molecule layer and the conductive substrate.

13. The method of Claim 12, further comprising forming a self-assembling organic layer, wherein the self-assembling organic layer is self-assembled on the surfaces of the semiconductor oxide layer exposed through the dye molecule layer and the conductive substrate by a chemical bond, for forming the insulating layer.

14. The method of Claim 13, wherein the forming of the self-assembling organic layer comprises dipping a resultant structure on which the dye molecule layer is formed, in a hydrophobic organic solvent in which at least one compound selected from the group consisting of a silane compound, a phosphate compound, a sulphuric acid compound, and a carboxylic acid compound is dissolved.

15. The method of Claim 13, wherein the forming of the self-assembling organic layer comprises providing in a gaseous state at least one compound selected from the group consisting of a silane compound, a phosphate compound, a sulphuric acid compound, and a carboxylic acid compound to the surface of the resultant structure on which the dye molecule layer is formed.

16. The method of any of Claims 13 to 15, wherein the forming of the self-assembling organic layer is performed under a drier condition than the atmosphere.
